# EUROPÄISCHE PATENTANMELDUNG

(11) **EP 2 413 357 A2**
(43) Veröffentlichungstag der Anmeldung: **01.02.2012**
(21) Anmeldenummer: 11172452.2
(22) Anmeldetag: 04.07.2011
(51) Int. Cl.: H01L 25/07, H01L 23/02

(54) **Leistungshalbleitermodul mit mindestens einer Positioniervorrichtung für ein Substrat**

(30) Priorität: 30.07.2010 DE 102010038723
(71) Anmelder: SEMIKRON Elektronik GmbH & Co. KG, 90431 Nürnberg (DE)
(72) Erfinder: Lederer, Marco, 90453 Nürnberg (DE); Popp, Rainer, 91580 Petersaurach (DE)

(57) **Zusammenfassung**

Die Erfindung betrifft ein Leistungshalbleitermodul mit einem rahmen- oder becherartigen Gehäuse und mit mindestens einer Ausnehmung für mindestens ein Substrat. Dieses Substrat ist nur als Schaltsubstrat oder als Grundplatte mit mindestens einem hierauf angeordneten Schaltsubstrat ausgebildet ist. Weiterhin weist das Gehäuse in dieser Ausnehmung mindestens eine Positioniervorrichtung mit einem federnden Abschnitt und einem Kontaktelement auf, wobei das mindestens eine Kontaktelement an einer zugeordneten Seitenfläche des Substrats kraftschlüssig anliegt und somit Druck hierauf ausübt.

## Beschreibung

Die vorliegende Erfindung betrifft ein kompaktes Leistungshalbleitermodul mit einem rahmen- oder becherartigen Gehäuse und mindestens einem Substrat, das mittels einer zugeordneten Positioniervorrichtung zu diesem Gehäuse des Leistungshalbleitermoduls angeordnet ist.

Einen Ausgangspunkt der Erfindung bilden Leistungshalbleitermodule, wie sie beispielhaft aus der EP 2 037 498 A1 bekannt sind. Diese offenbart ein Leistungshalbleitermodul mit einem Substrat mit hierauf angeordneten Leistungshalbleiterbauelementen sowie Hilfs- und Lastanschlusselementen. Ebenso ein Gehäuse mit einer Ausnehmung zur Aufnahme des Substrats. Eine Fixierung dieses Substrats zum Gehäuse erfolgt beispielsweise mittels einer Klebeverbindung.

Aus dem allgemeinen Stand der Technik sind weiter Ausgestaltungen von Leistungshalbleitermodulen bekannt, die ebenso ein Gehäuse mit einer Ausnehmung zur Aufnahme des Substrats aufweisen, wobei das Substrat in der Ausnehmung ausschließlich dadurch fixiert ist, dass das Gehäuse mit einer Vergußmasse gefüllt wird. Diese Vergußmasse ist beispielhaft als ein Silikongel ausgeführt, das sich nach dem Einfüllvorgang verfestigt und somit eine adhäsive Wirkung ausbildet, durch die das Substrat in der Ausnehmung des Gehäuses an dessen Rand haften bleibt.

Diese Verbindung mittels Vergußmasse, wie auch diejenige mittels eigener Klebeverbindung sind dahingehend nachteilig, dass das Substrat beim Verfestigen oder Aushärten die vorgesehene Lage einnehmen und eine gewisse Zeitspanne beibehalten muss. Eine präzise Positionierung des Substrats ist somit in einem üblichen Fertigungsprozess nur mit hohem Aufwand möglich. Zudem kann bei derartigen Befestigungen im Betrieb, induziert durch wechselnde Temperaturbelastung, die Verbindung teilweise unterbrochen werden, was möglicherweise zu Problemen bei der elektrischen Isolation des Substrats gegen einen Kühlkörper, auf dem das Leistungshalbleitermodul positioniert ist, führen kann.

Der Erfindung liegt die Aufgabe zugrunde ein Leistungshalbleitermodul vorzustellen bei dem die Anordnung des Substrats in einem Gehäuse verbessert ist und die einer einfachen Montage zu einem Leistungshalbleitermodul zugänglich ist.

Die Aufgabe wird erfindungsgemäß durch ein Leistungshalbleitermodul mit den Merkmalen des Anspruchs 1 gelöst. Bevorzugte Ausführungsformen sind in den abhängigen Ansprüchen beschrieben.

Der Erfindung liegt der Gedanke zugrunde mindestens eine dynamische Positioniervorrichtung im Gehäuse anzuordnen, welche eine kraftschlüssige Befestigung für ein Substrat ausbildet, wodurch Fertigungs- und Montagetoleranzen minimiert werden können.

Der erfinderische Gedanke geht aus von einem Leistungshalbleitermodul mit einem, vorzugsweise rahmen- oder becherartigen, Gehäuse und mindestens einem Substrat, das vorzugsweise zumindest teilweise eine Außenseite des Leistungshalbleitermoduls bildet. Ebenso kann das Gehäuse als ein Halterahmen in einem größeren leistungselektronischen Verbund sein und das Substrat hierzu geeignet angeordnet werden. Das Substrat selbst ist vorzugsweise als Schaltsubstrat oder als Grundplatte mit einem hierauf angeordneten Schaltsubstrat ausgebildet. Bekannte Schaltsubstrate sind hierbei beispielhaft IMS oder DCB Substrate, wobei das letztgenannte einen Isolierstoffkörper mit an dessen erster und zweiter Hauptfläche angeordneten metallischen Kaschierungen aufweist, und hierbei diejenige metallische Kaschierung, die dem Inneren des Leistungshalbleitermoduls zugewandt ist in sich strukturiert ist und somit voneinander isolierte Leiterbahnen ausbildet. Auf den Leiterbahnen des Substrats ist mindestens ein Leistungshalbleitermodul angeordnet. Das Leistungshalbleitermodul weist gemäß dem Stand der Technik noch Leistungshalbleiterbauelemente sowie Anschluss- und Verbindungselemente auf, deren konkrete Ausgestaltung allerdings nicht relevant für die hier vorgestellte Anordnung des Substrats zum Gehäuse ist.

Erfindungsgemäß ist das mindestens eine Substrat in einer zugeordneten Ausnehmung des Gehäuses angeordnet, wobei es bevorzugt ist das Substrat mittig in dieser Ausnehmung anzuordnen. Hierzu weist die Ausnehmung des Gehäuses mindestens eine, vorzugsweise jedoch mindestens drei, Positioniervorrichtungen auf. Ebenso ist es bevorzugt, wenn der mindestens einen Positioniervorrichtung mindestens ein, vorzugsweise jedoch wiederum mindestens drei, Widerlager für die mittige Anordnung zugeordnet ist. Hierbei kann dieses jeweilige Widerlager als Anschlagelement oder auch als eigene Positioniervorrichtungen im Sinne dieser Erfindung ausgebildet sein.

Eine Positioniervorrichtung ihrerseits weist einen federnden Abschnitt und ein Kontaktelement auf. Der federnde Abschnitt dient der Druckausübung auf das Substrat, wodurch das Kontaktelement kraftschlüssig an diesem Substrat anliegt. Das Kontaktelement weist hierzu vorzugsweise eine Anphasung auf um bei der Montage des Substrats in der Ausnehmung des Gehäuses diese Montage leicht ausführen zu können. Durch diese Anphasung wird der federnde Abschnitt bei der Montage durch das Anordnen des Substrats selbständig vorgespannt.

Bei jeglicher Ausgestaltung der mindestens einen Positioniervorrichtung mit federndem Abschnitt und Kontaktelement entsteht durch diese Vorspannung ein kraftschlüssiger Kontakt des Kontaktelements mit einer zugeordneten Seitenfläche des Substrats, wobei dieses in der Ausnehmung des Gehäuses angeordnet ist.

Grundsätzlich ist es möglich, die Positioniervorrichtung einteilig oder mehrteilig mit dem Gehäuse auszugestalten. Bei einer mehrteiligen Anordnung ist beispielsweise eine Steckverbindung jeweils gesondert ausgebildeter Positioniervorrichtungen mit dem Gehäuse vorsehbar.

Weiterhin ist es vorteilhaft, wenn die Kontaktfläche eines Kontaktelements einer Positioniervorrichtung oder eines Anschlagelementes zum Substrat jeweils nur 5 von 100 der gesamten Seitenfläche des Substrats beträgt. Vorzugsweise sind die Positioniervorrichtungen derartig zur jeweiligen Seitenfläche des Substrats angeordnet, dass das Substrat nicht nur mittig in der Ausnehmung zu liegen kommt, sondern auch, dass Rotationskräfte auf das Substrat möglichst geringe Kraft auf die federnden Abschnitte der Positioniervorrichtung ausüben. Daher ist es beispielhaft bevorzugt einer ersten Seitenfläche eines Substrats eine Positioniervorrichtung mittig zu dieser Seitenfläche anzuordnen. Einer zweiten, zu dieser ersten orthogonalen, Seitenfläche sind dann zwei Positioniervorrichtungen derart zugeordnet, dass die Krafteinleitung möglichst nahe der Ecken des Substrats erfolgt.

Die Anzahl und Ausbildung der Positioniervorrichtungen sind abhängig vom Gewicht und der Größe des Substrats, so dass es zu keiner zu hohen Druckbeaufschlagung des Substrats führt und zugleich eine ausreichende Positionierkraft auf das Substrat ausgeübt wird.

Der erfinderische Gedanke wird anhand der Ausführungsbeispiele in den Fig. 1 bis Fig. 6 näher erläutert.

Fig. 1 zeigt schematisch einen Ausschnitt einer ersten Ausgestaltung eines erfindungsgemäßen Leistungshalbleitermoduls in Schnittansicht.

Fig. 2 zeigt schematisch einen Ausschnitt einer zweiten Ausgestaltung eines erfindungsgemäßen Leistungshalbleitermoduls in Schnittansicht.

Fig. 3 zeigt eine dreidimensionale Ansicht einer dritten Ausgestaltung eines erfindungsgemäßen Leistungshalbleitermoduls.

Fig. 4 bis 6 zeigen verschiedene Ausführungsformen von Positioniervorrichtungen erfindungsgemäßer Leistungshalbleitermodule.

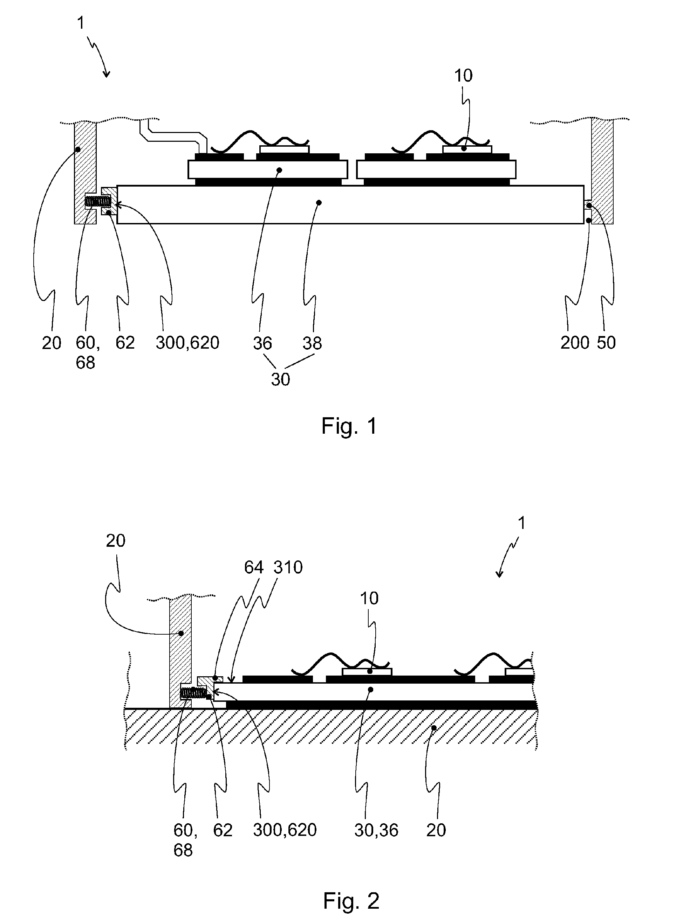

Fig. 1 schematisch einen Ausschnitt einer ersten Ausgestaltung eines erfindungsgemäßen Leistungshalbleitermoduls (1) mit einem Substrat (30), das hier als Grundplatte (38) mit einem hierauf angeordneten Schaltsubstrat (36) ausgebildet ist. Das Schaltsubstrat (36) seinerseits besteht aus einem Isolierstoffkörper mit an dessen erster und zweiter Hauptfläche angeordneten metallischen Kaschierungen, wobei die metallische Kaschierung auf der dem Inneren des Leistungshalbleitermoduls zugewandten Hauptfläche in sich strukturiert sind und somit voneinander isolierte Leiterbahnen ausbildet. Von den Leiterbahnen gehen Hilfs- und Lastanschlusselemente zur externen Verbindung des Leistungshalbleitermoduls aus.

Auf den Leiterbahnen der Schaltsubstrate sind Leistungshalbleiterbauelemente, wie Leistungsdioden und / oder Leistungsschalter meist in Form von Leistungstransistoren angeordnet und miteinander schaltungsgerecht verbunden.

Weiterhin weist das Leistungshalbleitermodul (1) ein rahmen- oder becherartiges Gehäuse (20) mit einer Ausnehmung (200) auf, in der das Substrat (30) angeordnet ist. Das Substrat bildet hier somit den Gehäuseboden des Leistungshalbleitermoduls (1) aus. Zur vorzugsweise mittigen Anordnung des Substrats (30) sind in der Ausnehmung (200) des Gehäuses (20) als Teil dieses Gehäuses eine Mehrzahl von Positioniervorrichtungen (60) vorgesehen, die jeweils im Kontakt zu zugeordneten Seitenflächen (300) des Substrats (30) stehen.

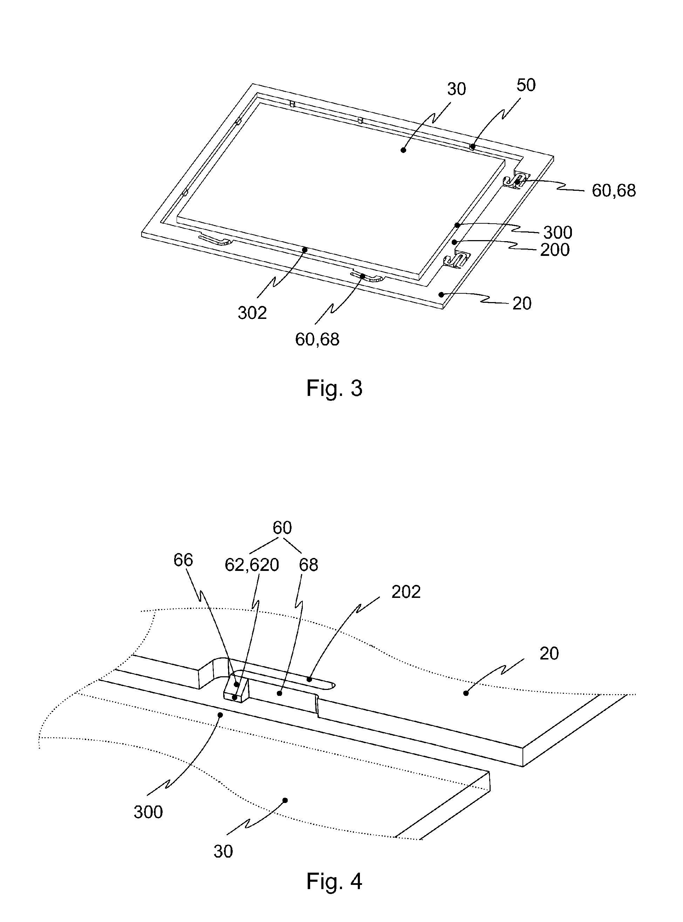

Hierbei weisen die Positioniervorrichtung (60) jeweils vorzugsweise einen federnden Abschnitt (68) und ein Kontaktelement (62) mit einer Kontaktfläche (620, vgl. auch Fig. 4 bis 6) auf. Mittels des federnden Abschnitts (68) wird dieses Kontaktelement (62) mit seiner Kontaktfläche (620) gegen die Seitenfläche (300) des Substrats (30) gedrückt und liegt dauerhaft kraftschlüssig an dieser an. Es ist hierbei bevorzugt, wenn die Größe der Kontaktfläche (620) eines Kontaktelements (62) nicht mehr als 5 von 100 der Größe der zugeordneten Seitenfläche (300) beträgt.

Zur Aufnahme der Druckkraft, bzw. zum Aufbau einer Gegenkraft, weist das Gehäuse (20) auf der gegenüberliegenden Seite der Positioniervorrichtung (60) dieser zugeordnet mindestens ein Widerlager (50) auf. Durch geeignete Ausgestaltung der Positioniervorrichtung (60) wie auch des Widerlagers (50) ist es möglich das Substrat (30) kraftschlüssig mittig in der Ausnehmung (200) des Gehäuses (20) anzuordnen. Hierbei ist es vorteilhaft aber nur in wenigen Anwendungsfällen notwendig, wenn die durch die Positioniervorrichtung (60) aufgebrachte Kraft ausreichend ist das Substrat (30) in der Ausnehmung (200) ohne weitere Hilfsmittel zu halten.

Fig. 2 zeigt schematisch einen Ausschnitt einer zweiten Ausgestaltung eines erfindungsgemäßen Leistungshalbleitermoduls (1) in Schnittansicht. Im Gegensatz zur Ausgestaltung gemäß Fig. 1 ist hier das Substrat (30) hier als Schaltsubstrat (36) ohne zusätzliche Grundplatte (38, vgl. Fig. 1)) ausgebildet. Zudem weist hier mindestens eine der Positioniervorrichtungen (60) einen Fortsatz (64) auf, der an einer dem Inneren des Leistungshalbleitermoduls zugewandten Fläche (310), einer Hauptfläche des Substrats (30), anliegt. Dieser Fortsatz (64) hat zusätzlich die Aufgabe eine Positionierung des Substrats (30) in Form eines Anschlags orthogonal zu den beiden grundlegenden Positionierrichtungen der Positioniervorrichtungen (60) zu gestatten. Die Positioniervorrichtungen (60), ggf. gemeinsam mit den zugeordneten Widerlagern (50) legen hierbei die horizontale Lage des Substrats (30) fest, während der Fortsatz (64) eine Bewegung des Substrats (30) in Richtung des Inneren des Leistungshalbleitermoduls (1) verhindert.

Fig. 3 zeigt eine dreidimensionale Ansicht einer dritten Ausgestaltung eines erfindungsgemäßen Leistungshalbleitermoduls. Dargestellt ist hier ein Teil eines Gehäuses (20), das hier nur als ein Halterahmen ausgebildet ist und eine Ausnehmung (200) zur Aufnahme eines Substrats (30) aufweist. Dieses ist verkleinert dargestellt um die Anordnung und Funktion der Positioniervorrichtungen (60) zur erläutern.

An zwei orthogonal zueinander angeordneten Innenflächen des Gehäuses (20) sind jeweils zwei Positioniervorrichtungen (60) vorgesehen, während auf den jeweils gegenüber liegenden Innenflächen zugeordnete Widerlager (50) vorgesehen sind. Auf der längeren Seite sind hier drei auf der kürzeren nur zwei dieser Widerlager (50) vorgesehen. Diese Widerlager (50) sind als vom Rand vorstehende Nasen ausgebildet und weisen jeweils eine Kontaktfläche mit der zugeordneten Seitenfläche des Substrats (30) auf deren Größe maximal 5 von 100 derjenigen der zugeordneten Seitenfläche beträgt.

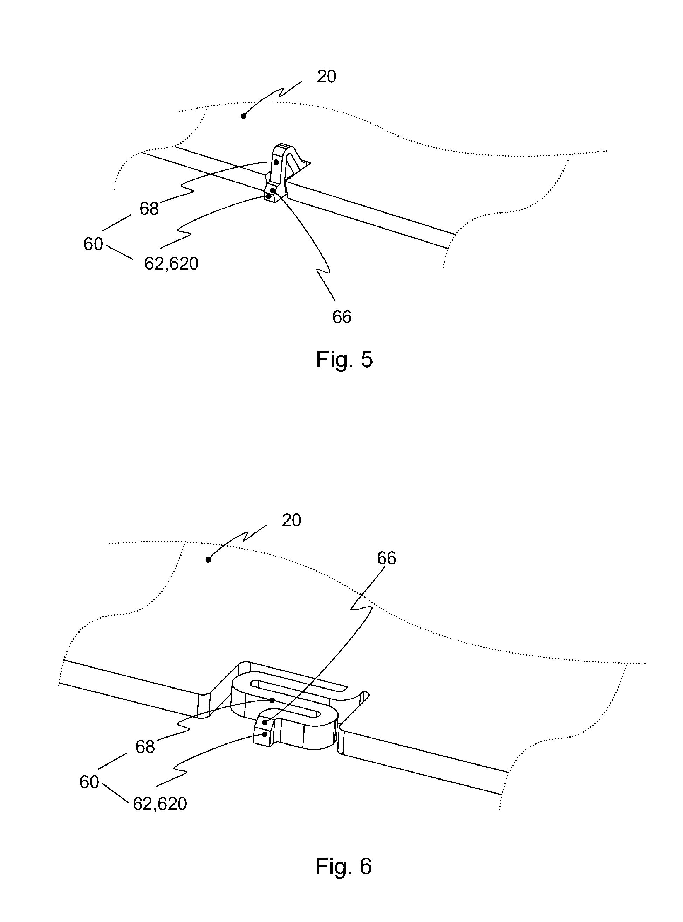

Die Positioniervorrichtungen (60) sind in zwei Ausgestaltungen, vorgesehen deren konkrete Ausgestaltung in den Fig. 4 bzw. 6 vergrößert dargestellt ist. Jede dieser Positioniervorrichtungen (60) weist einen federnden Abschnitt (68) und ein Kontaktelement (62) auf, das hier mit jeweils einer Anphasung (66) vorgesehen ist. Diese dient bei der Montage des Substrats (30) in der Ausnehmung (200) des Gehäuses (20) dazu die Positioniervorrichtungen (60) ohne weitere Hilfsmittel vorzuspannen. Nach der Montage liegen die Positioniervorrichtungen (60) mittels der Kontaktelemente (62) mit ihren Kontaktflächen (620) an den Seitenflächen (300, 302) des Substrats (30) an und erzeugen mittels der federnden Abschnitte (68) einen Kraftschluss zum Substrat (30), der durch die gegenüberliegenden Widerlager (50) seine Gegenkraft erfährt. Nach der Montage des Substrats (30) ist dieses somit für den weiteren Montageprozess des Leistungshalbleitermoduls und auch für dessen Betrieb mittig in der Ausnehmung des Gehäuses (20) zentriert.

Fig. 4 bis 6 zeigen verschiedene Ausführungsformen von Positioniervorrichtungen erfindungsgemäßer Leistungshalbleitermodule. Fig. 4 zeigt eine zusätzliche Freisparung (202) des Gehäuses und hierin in Richtung des Substrats vorstehend eine erste Ausgestaltung einer Positioniervorrichtung. Diese ist einstückig mit dem Gehäuse, das seinerseits aus einem geeigneten Kunststoff besteht, ausgebildet. Der federnde Abschnitt (68) ist hier als beweglicher Steg ausgebildet, an den das Kontaktelement (62) direkt anschließt. Dieses Kontaktelement (62) weist eine Kontaktfläche (620) zum kraftschlüssigen Kontakt mit einer Seitenfläche (300) des Substrats (30) auf. Zur leichteren Anordnung von Gehäuse (20) mit Positioniervorrichtung (60) und Substrat (30) zueinander weist das Kontaktelement (62) die bereits beschriebene Anphasung (66) auf.

Fig. 5 zeigt eine zweite Ausführungsform der Positioniervorrichtung (60) des Gehäuses (20). Der federnde Abschnitt (68) ist hierbei als Federbügel ausgebildet, der vorzugsweise in Richtung des Inneren des Leistungshalbleitermoduls ragt, wodurch eine sehr kompakte Ausgestaltung der Positioniervorrichtung (60) erzielt wird.

Fig. 6 zeigt eine dritte Ausführungsform der Positioniervorrichtung (60) des Gehäuses (20). Hierbei ist der federnde Abschnitt (68) wellenartig ausgebildet, wodurch eine höher Federkraft und gleichzeitig ein größerer Bewegungsbereich des Kontaktelements erreicht werden.

## Patentansprüche

1. Leistungshalbleitermodul (1) mit einem rahmen- oder becherartigen Gehäuse (20) mit mindestens einer Ausnehmung (200) für mindestens ein Substrat (30), das als Schaltsubstrat (36) oder als Grundplatte (38) mit mindestens einem hierauf angeordneten Schaltsubstrat (36) ausgebildet ist, wobei das Gehäuse (20) in dieser Ausnehmung (200) mindestens eine Positioniervorrichtung (60) mit einem federnden Abschnitt (68) und einem Kontaktelement (62) aufweist, wobei das mindestens eine Kontaktelement (62) an einer zugeordneten Seitenfläche (300, 302) des Substrats (30) kraftschlüssig anliegt und somit Druck hierauf ausübt.

2. Leistungshalbleitermodul (1) nach Anspruch 1,
wobei das Kontaktelement (60) quasi punktuell mit einer Kontaktfläche (620) von weniger als 5 von 100 der zugeordneten Seitenfläche (300, 302) an dieser anliegt.

3. Leistungshalbleitermodul (1) nach Anspruch 1,
wobei der mindestens einen Positioniervorrichtung (60) einer Seite mindestens ein Widerlager (50) an einer gegenüberliegenden Seite der Ausnehmung (200) des Gehäuses (20) zugeordnet ist und dieses als Anschlagelement ausgebildet ist.

4. Leistungshalbleitermodul (1) nach Anspruch 1,
wobei der mindestens einen Positioniervorrichtung (60) einer Seite mindestens ein Widerlager (50) an einer gegenüberliegenden Seite der Ausnehmung (200) des Gehäuses (20) zugeordnet ist, das ebenfalls als Positioniervorrichtung (60) ausgebildet ist.

5. Leistungshalbleitermodul (1) nach Anspruch 1,
wobei mindestens eine Positioniervorrichtung (60) einen Fortsatz (64) aufweist, der an einer dem Inneren des Leistungshalbleitermoduls zugewandten Fläche (310) einer Hauptfläche des Substrats (30) anliegt.

6. Leistungshalbleitermodul (1) nach Anspruch 1,
wobei einer ersten Seitenfläche (300) des Substrats (30) eine Positioniervorrichtung (60) und einer zweiten hierzu orthogonalen Seitenfläche (302) des Substrats (3) zwei Positioniervorrichtung (60) zugeordnet sind.

7. Leistungshalbleitermodul (1) nach Anspruch 1,
wobei das Kontaktelement (62) auf seiner dem Substrat (30) zugewandten Seite eine Anphasung (66) aufweist.

8. Leistungshalbleitermodul (1) nach Anspruch 1,
wobei die mindestens eine Positioniervorrichtung (60) und das Gehäuse (20) einstückig aus einem isolierenden Kunststoff ausgebildet sind.
